# EUROPEAN PATENT SPECIFICATION

(11) **EP 2 651 015 B1**
(45) Date of publication and mention of the grant of the patent: **18.12.2019**
(21) Application number: 11847839.5
(22) Date of filing: 31.01.2011
(51) Int. Cl.: H02K 11/00, F04B 35/04, F04D 13/06, F04D 29/58, H02K 5/08, H02K 5/128, H02K 11/215, H02K 9/22, H02K 11/33

(54) **MOTOR WITH EMBEDDED POWER CONVERSION CIRCUIT, LIQUID PUMP IN WHICH THIS MOTOR WITH EMBEDDED POWER CONVERSION CIRCUIT IS INSTALLED, AIR CONDITIONER IN WHICH THIS LIQUID PUMP IS INSTALLED, WATER HEATER IN WHICH THIS LIQUID PUMP IS INSTALLED, AND EQUIPMENT IN WHICH MOTOR WITH EMBEDDED POWER CONVERSION CIRCUIT IS INSTALLED**
MOTOR MIT EINGEBETTETER LEISTUNGSUMWANDLUNGSSCHALTUNG, FLÜSSIGKEITSPUMPE MIT DIESEM MOTOR MIT EINGEBETTETER LEISTUNGSUMWANDLUNGSSCHALTUNG, KLIMAANLAGE, IN DEM DIESE FLÜSSIGKEITSPUMPE INSTALLIERT IST, WASSERERHITZER, IN DEM DIESES FLÜSSIGKEITSPUMPE INSTALLIERT IST, UND ANLAGE MIT INSTALLIERTEM MOTOR MIT EINGEBETTETER LEISTUNGSUMWANDLUNGSSCHALTUNG
MOTEUR AVEC CIRCUIT INCORPORÉ DE CONVERSION DE PUISSANCE, POMPE À LIQUIDE DANS LAQUELLE EST INSTALLÉ LEDIT MOTEUR AVEC CIRCUIT INCORPORÉ DE CONVERSION DE PUISSANCE, CLIMATISEUR DANS LEQUEL EST INSTALLÉE LADITE POMPE À LIQUIDE, CHAUFFE-EAU DANS LEQUEL EST INSTALLÉE LADITE POMPE À LIQUIDE, ET ÉQUIPEMENT DANS LEQUEL EST INSTALLÉ LE MOTEUR AVEC CIRCUIT INCORPORÉ DE CONVERSION DE PUISSANCE

(30) Priority: 07.12.2010 JP 2010272327
(43) Date of publication of application: 16.10.2013
(73) Proprietor: Mitsubishi Electric Corporation, Tokyo 100-8310 (JP)
(72) Inventor: YAMADA, Michio, Tokyo 100-8310 (JP); MATSUOKA, Atsushi, Tokyo 100-8310 (JP); ASO, Hiroki, Tokyo 100-8310 (JP)
(74) Representative: Pfenning, Meinig & Partner mbB
(86) International application number: PCT/JP2011/000509
(87) International publication number: WO 2012/077246

(56) References cited:
- GB-A- 2 403 354
- JP-A- 11 234 948
- JP-A- 2007 116 840
- JP-A- 2010 141 279
- US-A1- 2007 205 038

## Description

### Technical Field

The present invention relates to a motor with a built-in power conversion circuit, a fluid pump including the motor with a built-in power conversion circuit, an air-conditioning apparatus and a water heater each including the fluid pump, and an apparatus including the motor with a built-in power conversion circuit.

### Background Art

In recent years, packages that seal semiconductor main devices (hereinafter referred to as main circuit devices) included in inverter circuits have become much smaller, and a growing number of packages intended for surface-mounting have become in use. Particularly, in response to demands for smaller discrete devices, the number of cases where packages intended for surface-mounting are used as main circuit devices to be mounted on the inside of motors have been increasing. A main circuit device to be used in a motor is desired to have a relatively high allowable power consumption and a superior heat-transferring characteristic. This requires some improvement in the mounting method. In this respect, there is a technology configured as follows (see Patent Literature 1, for example). A main circuit device is provided near an end of a printed-circuit board such that a lead of the main circuit device extends beyond the end of the printed-circuit board. Meanwhile, a metal heat-transferring plate is provided on the back of the printed-circuit board at a position opposing to the lead. The lead and the metal heat-transferring plate are soldered to
each other, whereby heat generated from the main circuit device is transferred to the outside from the metal heat-transferring plate via the lead.

In a known motor with a built-in power conversion circuit (see Patent Literature 2, for example), a printed-circuit board on which a surface-mount main circuit device is mounted and a stator of the motor are packaged by sealing with a highly heat-transferring resin, whereby heat generated from the main circuit device is transferred to the outside via the resin.
GB2403354A discloses an electric motor that includes a housing surrounding the stator, the housing end having the electronics mounted in a pancake configuration comprising power electronic ie bare power dies, a pancake capacitor, a cold plate and liquid cooled busbars forming the mount. A liquid power die attach surrounded by a sealant may be present between the die and the cooled busbar, an electrical interconnect liquid metal die attach, a interconnect substrate, sealent, thermal adhesive and a heat sink being present, the layers providing further cooling of the die.
US2007205038A1 discloses an electric power steering apparatus requires no external connecting member connecting between a power main body and a control main body, and hence can be reduced in size and cost, and the reliability of electrical connection between the power main body and the control main body can be improved. High current parts constituting the power main body and low current parts constituting the control main body are mounted on opposite sides of a circuit board, and are electrically connected with one another via conductor layers of the circuit board and through holes formed therein.

### Citation List

### Patent Literature

Patent Literature 1: Japanese Unexamined Patent Application Publication No. 5-249666 (Fig. 1 and p. 2)
Patent Literature 2: Japanese Unexamined Patent Application Publication No. 2010-183797 (Fig. 4 and [0026])

### Summary of Invention

### Technical Problem

In Patent Literature 1, the printed-circuit board radially extends beyond and projects from the outer circumference of the stator of the motor, and the main circuit device is provided at the end of the projecting portion of the printed-circuit board. Such a configuration does not sufficiently produce an effect of size reduction produced by the use of a surface-mount device.

In Patent Literature 2, although the heat generated from the main circuit device is transferred to the outside air via the resin, there are no particular flows of air on the outside of the resin. Hence, even if the heat is transferred to the air, the heat may remain still. Therefore, further improvement in the heat-transferring characteristic is awaited.

In recent years, in response to demands for efficient transfer of heat generated from device chips, surface-mount packages have also been proposed in each of which a metal heat spreader is incorporated in a package including a device chip. In such a surface-mount package, the metal heat spreader is partially sealed such that a portion of the surface thereof is exposed. In a case where a main circuit device of this type is applied to a motor with a built-in power conversion circuit, a configuration is employed in which a metal heat spreader is directly in contact with highly heat-transferring resin, which is provided for packaging, so that heat is transferred from the resin to the air. In this configuration, for the purposes of heat transfer from the metal heat spreader and insulation, the highly heat-transferring resin needs to be made thick. This leads to a problem in that the size reduction is difficult.

A surface-mount device has a small package size. Therefore, if no heat is transferred to the outside for a specific amount of heat generated, the temperature of the device rises significantly. In such a case, the maximum output needs to be limited. This narrows the operating range as a power conversion circuit. In Patent Literature 2, the surface-mount main circuit device is provided on a side of the stator, on which the temperature becomes high because of heat generated from the motor. This also leads to a problem in that the operating range is further narrowed.

A surface-mount device is soldered to a printed-circuit board by reflow soldering. In reflow soldering, the amount of solder is in general smaller than that used in DIP (flow) or manual soldering, and the mechanical strength at the soldered part is low. Hence, a mechanically strong soldered joint for a surface-mount device is to be achieved. A main circuit device included in a power conversion circuit generates a larger amount of heat than devices such as microprocessors. Furthermore, the rise of temperature around the main circuit device is greater, and the distortion at the soldered part due to thermal contraction stress is greater. Hence, solder around the lead of the main circuit device tends to break easily. The life of electrical bonding at the soldered part determined by the low solder strength and the thermal contraction resulting from such surface-mounting is regarded as the life of a power-conversion-circuit board. Therefore, it is an important issue to improve the strength of the mechanical coupling between the main circuit device and the printed-circuit board. This issue directly concerns the lives of a motor with a built-in power conversion circuit and an apparatus including the same.

In a case where the temperature of the main circuit device is to be lowered by using metal heat-transferring fins, screwing or the like is usually necessary in attaching the heat-transferring fins. This increases the processing cost.

The present invention is to solve the above problems, and a first object of the present invention is to provide a motor with a built-in power conversion circuit that is small in size and has a superior heat-transferring characteristic.

A second object of the present invention is to provide a motor with a built-in power conversion circuit that has a wide operating range with an improved heat-transferring characteristic.

A third object of the present invention is to provide a motor with a built-in power conversion circuit that has a long life with an increased strength at a mechanical coupling between a main circuit device and a printed-circuit board and thus has improved reliability.

A fourth object of the present invention is to provide a motor with a built-in power conversion circuit that reduces manufacturing cost.

A fifth object of the present invention is to provide a fluid pump including the motor with a built-in power conversion circuit, an air-conditioning apparatus and a water heater each including the fluid pump, and an apparatus including the motor with a built-in power conversion circuit.

### Solution to Problem

A motor with a built-in power conversion circuit according to the present invention is defined in claim 1. It includes a printed-circuit board on which a power conversion circuit including a package of a surface-mount main circuit device is mounted; a stator provided on a stator-side surface of the printed-circuit board that is a reverse surface of a mounting surface having the main circuit device; a cup providing a space therein in which a fluid flows, the cup being provided on an inner side of the stator such that the cup is in contact with or in proximity to the printed-circuit board; and heat-transferring copper foil provided over an area of the surface of the printed-circuit board that is the reverse surface of the mounting surface, the area facing a bottom of the cup. In the main circuit device, a heat spreader is bonded to one of two surfaces of a device chip included in the package, the one of the two surfaces facing toward the printed-circuit board in an orientation for mounting onto the printed-circuit board. The heat spreader is coupled to the heat-transferring copper foil via a through hole penetrating through the printed-circuit board.

A fluid pump according to the present invention includes the above motor with a built-in power conversion circuit.

An air-conditioning apparatus according to the present invention includes the above fluid pump.

A water heater according to the present invention includes the above fluid pump.

An apparatus according to the present invention includes the above motor with a built-in power conversion circuit.

### Advantageous Effects of Invention

According to the present invention, heat generated from the main circuit device is transferred to the fluid flowing through the space in the cup. Therefore, the heat-transferring characteristic is improved.

Since the heat-transferring characteristic is improved, the surface area of the motor can be reduced. Therefore, a small and light motor can be provided.

Since the allowable power dissipation increases with such an improved heat-transferring mechanism, the upper operating-temperature limit of the motor is raised. Consequently, the operating range of the motor is widened.

In the main circuit device, the heat spreader is bonded to one of two surfaces of the device chip included in the package, the one of the two surfaces facing toward the printed-circuit board in the orientation for mounting onto the printed-circuit board. Furthermore, the heat spreader is bonded to the printed-circuit board by the surface thereof. Hence, the strength at the mechanical coupling between the main circuit device and the printed-circuit board increases.

Furthermore, since no heat-transferring fins are necessary, the manufacturing cost is reduced.

### Brief Description of Drawings

[Fig. 1] Fig. 1 is a diagram illustrating a configuration of a motor according to Embodiment 1 of the present invention, excluding a bracket thereof.
[Fig. 2] Fig. 2 is a diagram illustrating an internal configuration of a main circuit device illustrated in Fig. 1.
[Fig. 3] Fig. 3 is a schematic sectional view illustrating major elements of the motor according to Embodiment 1 of the present invention.
[Fig. 3A] Fig. 3A is a diagram illustrating a modification of Fig. 3.
[Fig. 4] Fig. 4 is a sectional view illustrating a configuration of a fluid pump according to Embodiment 2 of the present invention.
[Fig. 5] Fig. 5 is a diagram of a refrigerant circuit included in an air-conditioning apparatus according to Embodiment 3 of the present invention.
[Fig. 5A] Fig. 5A is a diagram illustrating a specific configuration of the refrigerant circuit included in the air-conditioning apparatus according to Embodiment 3 of the present invention.
[Fig. 6] Fig. 6 is a diagram of a refrigerant circuit forming a water heater according to Embodiment 4 of the present invention.
[Fig. 7] Fig. 7 is a circuit diagram of a motor with a built-in power conversion circuit according to Embodiment 8 of the present invention.
[Fig. 8] Fig. 8 is a circuit diagram illustrating a superheat protection circuit, a shunt resistor RS, and peripheral elements illustrated in Fig. 7.
[Fig. 9] Fig. 9 illustrates another exemplary configuration of a circuit including the superheat protection circuit, the shunt resistor RS, and peripheral elements illustrated in Fig. 7.

### Description of Embodiments

### Embodiment 1

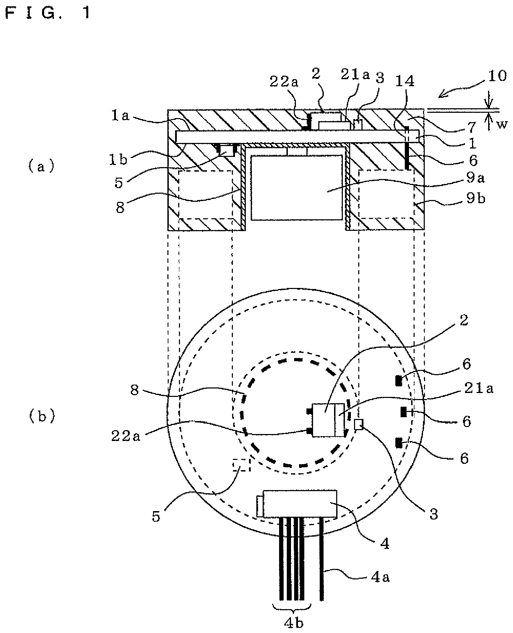

Fig. 1 is a diagram illustrating a configuration of a motor according to Embodiment 1 of the present invention, excluding a bracket thereof. Part (a) is a side sectional view, and part (b) is a top perspective view. The top, bottom, right, and left sides to be referred to in the following description of the drawings correspond to the top, bottom, right, and left sides, respectively, in Fig. 1(a).

A printed-circuit board 1 has a disc shape and on which a power conversion circuit that drives a motor 10 is mounted. The power conversion circuit is a conventionally known power conversion circuit and includes a main circuit. The main circuit includes at least one switching device and a freewheeling diode that is connected in inverse-parallel to the switching device. Fig. 1 illustrates a main circuit device 2 as a switching device included in the power conversion circuit. The main circuit device 2 forms a main circuit of a voltage-type inverter that applies a voltage to a stator coil of the motor 10. The main circuit device 2 may be a so-called modularized device.

A superheat-detecting device 3 as temperature-detecting means and a motor-external-connection lead 4 are also mounted on a mounting surface 1a of the printed-circuit board 1 on which the main circuit device 2 is mounted. The superheat-detecting device 3 is provided near a heat spreader 21 to be described below and detects the superheat of a main device chip 20 to be described below. If the superheat is detected, the operation of the main circuit device 2 is limited (the output of the inverter is limited, the operation of the inverter is stopped, or any other limitation is made) by a protection circuit (not illustrated) provided in the power conversion circuit. The motor-external-connection lead 4 is a bundle of input/output lines (a high-voltage input line 4a and low-voltage input lines 4b) that connect the motor 10 and an external circuit. A surface-mount Hall device 5 is mounted on a surface 1b of the printed-circuit board 1 that is the reverse surface of the mounting surface 1a having the main circuit device 2. The Hall device 5 detects the speed or position of rotation of a rotor 9a on the basis of changes in the density of magnetic flux lines generated by the rotor 9a.

A stator 9b including a stator core and coil wires wound therearound is provided below the printed-circuit board 1. The coil wires of the stator 9b and the printed-circuit board 1 are electrically connected to each other via motor terminals 6. The motor terminals 6 are connection terminals of a high-voltage motor intended for a direct-current power source obtained through the full-wave rectification or voltage-doubler rectification of a commercial power source. To mechanically couple the printed-circuit board 1 and the stator 9b while providing a bearing housing, the printed-circuit board 1 and the stator 9b are sealed with molded resin 7 having a higher thermal conductivity (a lower thermal resistance) than air. A cup 8 made of resin and having a cylindrical shape with a closed end is provided in a space on the inner side of the stator 9b, which has an annular shape. The closed end of the cup 8 is in contact with or in proximity to the surface of the printed-circuit board 1 that faces toward the stator (the surface will be hereinafter referred to as stator-side surface 1b). With the cup 8, the space in the cup 8 and the space outside the cup 8 are separated from each other. A fluid flows through the space in the cup 8. The fluid has a temperature at or below the heat-resistant temperature of the printed-circuit board 1 and circulates through the motor 10. The rotor 9a, which is integrated with an impeller 31 (not illustrated), is provided in the space in the cup 8. In terms of size reduction and improvement in the heat-transferring characteristic, preferably, the cup 8 is thin while providing a required strength and is made of a resin having a high thermal conductivity.

As described above, the printed-circuit board 1 having the main circuit device 2 and other elements mounted thereon is electrically and mechanically coupled to the stator 9b of the motor 10 into an integral body, and the integral body is sealed with resin, whereby a motor with a built-in power conversion circuit that includes a power conversion circuit is provided.

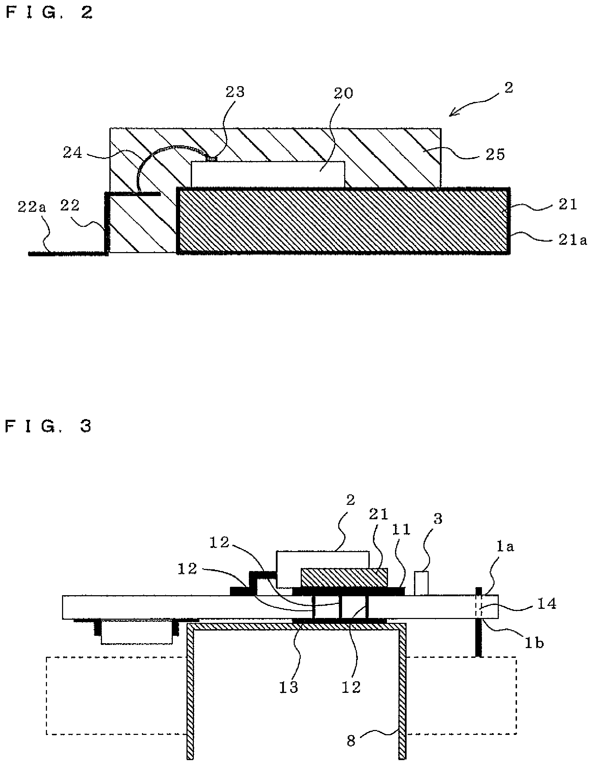

Fig. 2 is a diagram illustrating an internal configuration of the switching device illustrated in Fig. 1. The switching device is packaged as an IC package. In Fig. 2, the surface-mount main circuit device 2 as an IC package includes the main device chip 20 made of silicon, the heat spreader 21 made of metal and being thicker than the main device chip 20, a high-voltage electrode 21a, and a low-voltage electrode 22a. The heat spreader 21 is soldered to one of two surfaces of the main device chip 20 that faces toward the printed-circuit board 1 in an orientation for mounting onto the printed-circuit board 1. The heat spreader 21 and the main device chip 20 are electrically, thermally, and mechanically coupled to each other. In such a configuration, a transient portion of heat generated from the main device chip 20 is stored in the heat spreader 21 , whereby a transient rise of temperature in the main device chip 20 is suppressed.

A metal electrode 23 provided on the upper surface of the main device chip 20 is electrically connected to a metal lead frame 22 via a bonding wire 24. The bonding wire 24 is a metal wire made of gold or aluminum and electrically bonds the metal lead frame 22 and the main device chip 20 together by being ultrasonically welded thereto. Alternatively, as in a recent-year technology of direct bonding, the metal lead frame 22 and the main device chip 20 may be directly in contact with each other so as to be electrically coupled to each other. The bonding wire 24, the main device chip 20, a portion of the metal lead frame 22, and a portion of the heat spreader 21 are sealed with resin 25 having a high thermal conductivity, whereby an IC package is provided. In the IC package, a portion of the metal lead frame 22 that is exposed to the outside of the seal functions as the low-voltage electrode 22a, and a portion of the heat spreader 21 that is exposed to the outside of the seal functions as the high-voltage electrode 21a.

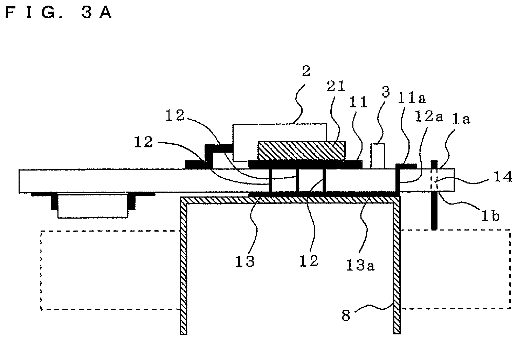

Fig. 3 is a schematic sectional view illustrating major elements of the motor according to Embodiment 1 of the present invention. In Fig. 3, elements that are the same as those illustrated in Figs. 1 and 2 are denoted by the reference numerals corresponding thereto. In all drawings including those to be referred to below, like elements are denoted by like reference numerals.

The printed-circuit board 1 has on both surfaces thereof copper foil 11 provided as lands on which various electronic components (not illustrated except the main circuit device 2) including circuit-wiring patterns and the main circuit device 2 are mounted. The electronic components (not illustrated) are electrically, thermally, and mechanically coupled to the lands with solder. The heat-transferring copper foil 13 is provided over an area of the surface (hereinafter also referred to as stator-side surface) 1b of the printed-circuit board 1 that is a reverse surface of the mounting surface (hereinafter also referred to as counter-stator-side surface) 1a having the main circuit device 2, the area facing the closed end of the cup 8. The printed-circuit board 1 has a plurality of through holes 12 connected to the heat-transferring copper foil 13. The copper foil 11 on the mounting surface 1a extends over the openings of the plurality of through holes 12. The heat spreader 21 included in the main circuit device 2 is soldered to the copper foil 11. Thus, the heat spreader 21 is electrically, mechanically, and thermally coupled to the heat-transferring copper foil 13 on the stator-side surface 1b via the copper foil 11 and the plurality of through holes 12.

A path along which heat generated from the main device chip 20 is transferred to the outside will now be described.

Heat generated from the main device chip 20 is transferred to the heat spreader 21, the copper foil 11, the through holes 12, the heat-transferring copper foil 13, and the cup 8 in that order. Since the cup 8 is in contact with or in proximity to the heat-transferring copper foil 13, the heat-transferring copper foil 13 is thermally coupled to the fluid in the cup 8. Hence, the heat that has been transferred to the heat-transferring copper foil 13 is transferred to the cup 8 and is then transferred from the surface of the cup 8 to the fluid in the cup 8.

The motor 10 according to Embodiment 1 is used as, for example, a motor for a pump. A fluid such as water flows inside the cup 8. The operating temperature of the main device chip 20 is 150 degrees C for silicon and 200 degrees C for silicon carbide. The fluid has a temperature lower than the heat-resistant temperature (100 degrees C, for example) of the printed-circuit board 1, as described above. Therefore, the cup 8 itself and the space in the cup 8 are at lower temperatures than the other parts of the motor 10.

Heat generated from the main device chip 20 resulting from any loss occurring in the main circuit device 2 is transferred to the outside of the motor structure via the fluid and along the above heat-transferring path. In such a configuration, no metal heat-transferring fins are necessary. Accordingly, manual work such as screwing that is necessary if any metal heat-transferring fins are employed is unnecessary. Furthermore, the heat-transferring characteristic is improved compared with that of a conventional motor in which heat is transferred to the ambient still air via the molded resin 7. Embodiment 1 concerns a case where the motor 10 is used as a motor for a pump and water as the fluid flows through the motor 10. Alternatively, the motor 10 may be used as a motor for any other purposes, and the fluid may be air, for example.

A process of manufacturing the printed-circuit board 1 illustrated in Fig. 1 will now be described.

First, printing is performed with solder cream on both surfaces of the printed-circuit board 1. In this step, lands for the connection of the motor-external-connection lead 4 and the motor terminals 6 are covered with a metal mask so that the solder cream is not applied thereto. Then, the metal mask is removed. Subsequently, the main circuit device 2 and the superheat-detecting device 3 are placed on the counter-stator-side surface 1a of the printed-circuit board 1 and are electrically and mechanically coupled to the copper foil by reflow soldering. During this reflow soldering, the heat spreader 21 included in the main circuit device 2 is soldered to the copper foil 11 and is coupled to the copper foil 11 electrically, mechanically, and thermally at a time. Since the heat spreader 21 to which the main device chip 20 is soldered as described above is bonded to the printed-circuit board 1 by the surface thereof, the strength at the mechanical coupling between the main device chip 20 and the printed-circuit board 1 increases dramatically, compared with a case of normal coupling using a lead. Hence, even in a configuration in which the power conversion circuit is provided in a motor that vibrates, high reliability is provided.

The inner peripheral surfaces of the plurality of through holes 12 provided below the heat spreader 21 are plated with copper. Hence, the solder cream provided between the printed-circuit board 1 and the heat spreader 21 during the reflow soldering spreads into the through holes 12, whereby the heat spreader 21 is also thermally coupled to the heat-transferring copper foil 13 provided on the stator-side surface 1b of the printed-circuit board 1. In this manner, components to be mounted on the counter-stator-side surface 1a of the printed-circuit board 1 are electrically and mechanically coupled at a time by reflow soldering. Simultaneously, the heat spreader 21 is thermally coupled to the heat-transferring copper foil 13.

Subsequently, after the Hall device 5 is temporarily attached with adhesive to the stator-side surface 1b of the printed-circuit board 1 on which surface-mount components such as the main circuit device 2 and the superheat-detecting device 3 have been mounted, the Hall device 5 is bonded to the stator-side surface 1b by flow soldering. Furthermore, the printed-circuit board 1 on which all the electronic components have been mounted is attached to the upper side of the stator 9b. In this state, a connector for the motor-external-connection lead 4 is soldered, and the coil wires of the stator 9b are made to pass through the through holes 12 and are connected to the motor terminals 6.

According to the above manufacturing process, the lands for the connection of the motor-external-connection lead 4 and the stator terminals are covered with a metal mask during printing with solder cream. Therefore, through holes used in later providing other components including the connector for the motor-external-connection lead 4 and through holes 14 used in later providing the stator terminals are prevented from being filled with solder during reflow soldering. In a case of flow soldering, a step of applying masking tape so as to prevent the through holes from being filled and a step of removing the masking tape after performing flow soldering are necessary. To perform such masking and removing steps, manual work is necessary. In contrast, in Embodiment 1, relevant parts are covered with a metal mask when solder cream is applied. Therefore, the steps of applying and removing the masking tape are unnecessary. This enables the automated production of printed-circuit boards 1. Furthermore, the manufacturing process is simplified without the use of masking tape. This also produces an effect of reducing environmental loads caused by the manufacture thereof.

As described above, in Embodiment 1, heat generated from the main device chip 20 is transferred to the heat-transferring copper foil 13 provided on the stator-side surface 1b of the printed-circuit board 1 via the heat spreader 21 and the plurality of through holes 12, and is further transferred from the heat-transferring copper foil 13 to the fluid flowing through the space in the cup 8 via the closed end of the cup 8. Since such a configuration is employed in which heat generated from the main device chip 20 is transferred to the fluid flowing through the space in the cup 8, the heat-transferring characteristic is improved compared with that of the configuration in which heat generated from the main device chip 20 is transferred to the outside air via the molded resin provided around the main device chip 20.

Since the heat-transferring characteristic is improved, the surface area of the motor 10 can be reduced. Therefore, a small and light motor can be provided. Moreover, since the allowable power dissipation increases with such an improved heat-transferring mechanism, the motor 10 can produce a higher output than other configurations (for example, the configuration in which heat generated from the main device chip 20 is transferred to the outside air via the molded resin 7 provided around the main device chip 20) each having the same outer dimensions as the motor 10. That is, the operating range of the motor 10 is widened.

Since the main circuit device 2 is provided on the inner side of the contour of the stator 9b, the contour shape can be made smaller than that of a conventional configuration in which the main circuit device 2 is provided in a portion radially projecting beyond the outer circumference of the stator 9b. Furthermore, the effect of size reduction produced by the use of surface-mount components is not deteriorated.

In the conventional configuration in which heat generated from the main device chip 20 is transferred from the heat spreader 21 to the ambient air via the molded resin 7, the heat spreader 21 is provided on one of two surfaces of the main device chip 20 that is opposite the surface facing toward the printed-circuit board 1. Hence, a thickness w (see Fig. 1) of the molded resin 7 that covers the main circuit device 2 needs to be large. In contrast, in the configuration according to Embodiment 1, the heat spreader 21 is provided on one of two surfaces of the main device chip 20 that faces toward the printed-circuit board 1, and heat received by the heat spreader 21 is transferred to heat-transferring copper foil 13 via the through holes 12 of the printed-circuit board 1 and is further transferred toward the fluid. Hence, the thickness w can be made small. Accordingly, the size and the weight of the motor 10 can be reduced.

As illustrated in Fig. 3, the superheat-detecting device 3 is provided near the heat spreader 21, which is strongly thermally coupled to the main device chip 20. Accordingly, the superheat-detecting device 3 is strongly thermally coupled to the main device chip 20 and accurately detects the superheat of the main device chip 20. Furthermore, since the molded resin 7 having a low thermal resistance is provided around the main circuit device 2, the thermal coupling between the heat spreader 21 and the superheat-detecting device 3 is made stronger and the detection accuracy is increased. Consequently, the motor 10 can operate until the moment immediately before the temperature reaches the limit for the main device chip 20. In this respect also, the maximum output is increased, and the operating range is thus widened.

Since the main circuit device 2 is bonded to the printed-circuit board 1 by the surface of the heat spreader 21, the main circuit device 2 is mounted on and coupled to the printed-circuit board 1 with a sufficient mechanical strength through a single performance of reflow soldering. Hence, the conventional problem of solder breakage is solved.

Since the heat-transferring structure requires no metal heat-transferring fins, manual work such as screwing is unnecessary, reducing the manufacturing cost.

If a positive-coefficient thermal resistor element made of ceramic and whose resistance changes significantly with temperature is employed as the superheat-detecting device 3, the superheat of the main device chip 20 is detected remarkably accurately. When the superheat is detected, protection is provided by limiting the operation.

The superheat-detecting device 3 is provided near the main shaft of the motor 10 or the cup 8 and is strongly thermally coupled. Hence, the superheat of the fluid due to the superheat of a refrigerant and the superheat due to irregular friction on the main shaft of the rotor are also detectable for protection.

To increase the detection accuracy of the superheat-detecting device 3, a configuration illustrated in Fig. 3A may be employed. Specifically, the copper foil 11 that is strongly thermally coupled to the heat spreader 21 may be lengthened along the printed-circuit board 1 in such a manner as to surround the superheat-detecting device 3. Furthermore, as with the heat of the main device chip 20, the heat of a portion of the copper foil 11 (11a) surrounding the superheat-detecting device 3 is thermally coupled to the heat-transferring copper foil 13 via a through hole 12a, whereby the heat is transferred to the heat-transferring copper foil 13. The heat-transferring copper foil 13 illustrated in Fig. 3A is longer than the heat-transferring copper foil 13 illustrated in Fig. 3 and extends up to an area facing the superheat-detecting device 3. Such a configuration facilitates the reception of the heat of the main circuit device 2 by the superheat-detecting device 3, increasing the detection accuracy. Consequently, thermal protection is provided with a reduced time lag in detection and reduced errors in detected temperature.

Furthermore, since the thermal coupling is enhanced by surrounding the superheat-detecting device 3 with the copper foil 11 (11a) that is strongly thermally coupled to the fluid flowing through the space in the cup 8, the detection of the superheat of the fluid for a protection purpose is performed accurately.

### Embodiment 2

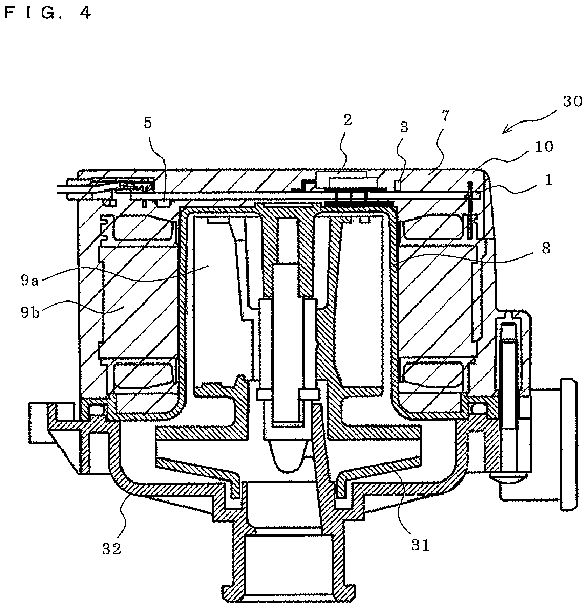

Fig. 4 is a sectional view illustrating a configuration of a fluid pump according to Embodiment 2 of the present invention. In Fig. 4, elements that are the same as those illustrated in Fig. 1 are denoted by the reference numerals corresponding thereto.

A fluid pump 30 according to Embodiment 2 includes the motor 10 according to Embodiment 1 and a substantially disc-shaped impeller 31 included in the rotor 9a of the motor 10. The fluid pump 30 sucks a fluid into a pump housing 32 and discharges the fluid out of the pump housing 32 by using the impeller 31, which rotates together with the rotor 9a.

Since the fluid pump according to Embodiment 2 includes the motor 10 according to Embodiment 1, a pump that produces the effects described in Embodiment 1 is provided.

### Embodiment 3

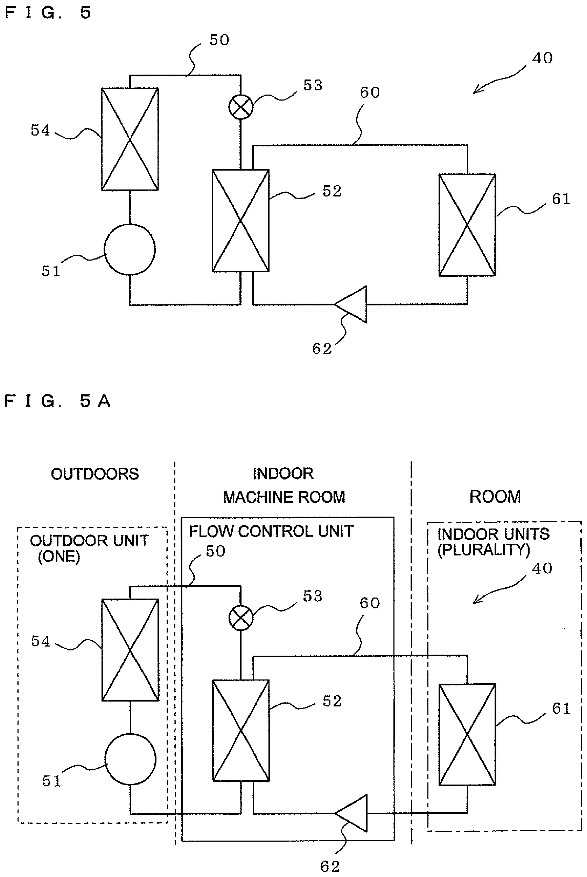

Fig. 5 is a diagram of a refrigerant circuit included in an air-conditioning apparatus according to Embodiment 3 of the present invention.

An air-conditioning apparatus 40 according to Embodiment 3 includes a refrigeration cycle section 50 and a water circuit 60. The refrigeration cycle section 50 includes a compressor 51 that compresses a refrigerant, a water-refrigerant heat exchanger 52, an expansion valve 53, and a refrigerant-air heat exchanger 54 that are annularly connected to one another in that order with refrigerant pipes, whereby a refrigerant circuit is provided. The water circuit 60 includes the water-refrigerant heat exchanger 52, a water-air heat exchanger 61, and a pump 62. Water pipes connected to the water-refrigerant heat exchanger 52 are separated from the refrigerant pipes of the refrigerant circuit. The water-refrigerant heat exchanger 52, the water-air heat exchanger 61, and the pump 62 included in the water circuit 60 are annularly connected to one another in that order with the water pipes. The pump 62 corresponds to the fluid pump 30 according to Embodiment 2 described above. The water-refrigerant heat exchanger 52 and the refrigerant-air heat exchanger 54 are provided in an outdoor unit that is installed outdoors. The water-air heat exchanger 61 is provided in an indoor unit that is installed indoors. In recent years, the air-conditioning apparatus 40 configured as described above has been rapidly spreading as a substitute for a conventional apparatus in which a boiler is provided outdoors and heat transfer to an indoor space is realized by using circulating water that circulates through the water circuit 60. The air-conditioning apparatus 40 is mainly intended for heating.

An operation of the refrigeration cycle section 50 will first be described.

A high-temperature, high-pressure gas refrigerant discharged from the compressor 51 flows into the water-refrigerant heat exchanger 52, where the gas refrigerant exchanges heat with the water flowing through the water pipe by transferring its heat to the water, whereby the gas refrigerant is condensed into a liquid refrigerant. The liquid refrigerant undergoes pressure reduction at the expansion valve 53, turns into a low-pressure, two-phase gas-liquid refrigerant or a liquid refrigerant, and flows into the refrigerant-air heat exchanger 54. In the refrigerant-air heat exchanger 54, the low-pressure refrigerant absorbs heat from the outdoor air and thus evaporates, thereby turning into a gas refrigerant. The gas refrigerant is sucked into the compressor 51 again. Thereafter, the above sequence is repeated.

A basic operation of the water circuit 60 will now be described.

The water circulating through the water circuit 60 is sent to the water-refrigerant heat exchanger 52 by the pump 62 and is heated in the water-refrigerant heat exchanger 52 by the heat transferred from the refrigeration cycle section 50. The heated water is sent to the water-air heat exchanger 61 and is condensed by transferring its heat to the indoor air, whereby a heating effect is produced. The water condensed in the water-air heat exchanger 61 is sent to the pump 62 again. Thereafter, the above sequence is repeated.

Here, the temperature of the circulating water, as a fluid, flowing through the water circuit 60 is 60 degrees C at highest. This temperature is far lower than the operating temperature of the main device chip 20 (150 degrees C for silicon, and 200 degrees C for silicon carbide) and the heat-resistant temperature (100 degrees C) of the printed-circuit board 1 made of composite materials. Hence, a large amount of heat can be transferred from the main device chip 20 to the fluid while a certain level of reliability is maintained.

According to the above configuration, the air-conditioning apparatus 40 including the motor 10 produces the same effects as in Embodiment 1. Heat of the power conversion circuit included in the motor 10 is transferred to the circulating water intended for heating that circulates through the water circuit 60. Therefore, the heat of the power conversion circuit is also efficiently used for heating, producing a possible effect of energy saving to some extent.

The configuration of the air-conditioning apparatus 40 including the motor 10 illustrated in and described referring to Fig. 5 is only exemplary and is not limited to the one illustrated in Fig. 5.

Although the above description does not include description of a specific arrangement of the devices included in the refrigerant circuit illustrated in Fig. 5, the devices may be arranged as illustrated in Fig. 5A, for example, whereby a water air-conditioning system (an air-conditioning apparatus) is provided. Specifically, the pump 62, the water-refrigerant heat exchanger 52, and the expansion valve 53 are provided in a flow control unit that is provided in an indoor machine room; the water-air heat exchanger 61 is provided in each of a plurality of indoor units that are provided in individual rooms; and the compressor 51 and the refrigerant-air heat exchanger 54 are provided in an (one) outdoor unit.

If the flow control unit is provided indoors, hot water pipes extending from the plurality of indoor units can be connected to the indoor machine room in which the ambient temperature is higher than in the outdoor space. Hence, the leakage of the heat of the circulating water is reduced. Consequently, the heating efficiency becomes higher than in a case where the flow control unit is provided outdoors. Instead, the pump 62 needs to be provided in the machine room in which the ambient temperature is higher than in the outdoor space. Therefore, the amount of heat that is transferred by the system during heating is limited in accordance with the upper limit of operating temperature of the pump 62. Accordingly, the pump to be applied to this system needs to have a high upper limit of operating temperature. The pump 62 according to Embodiment 3 meets this need as described above. Hence, a water air-conditioning system (an air-conditioning apparatus) realizing a large amount of heat transfer is provided.

Needless to mention, the above effects are produced not only in an air-conditioning apparatus in which the temperature of circulating water is about 60 degrees C. The same effects are also fully produced in a water heater described below in which hot water at about 80 degrees C is used.

### Embodiment 4

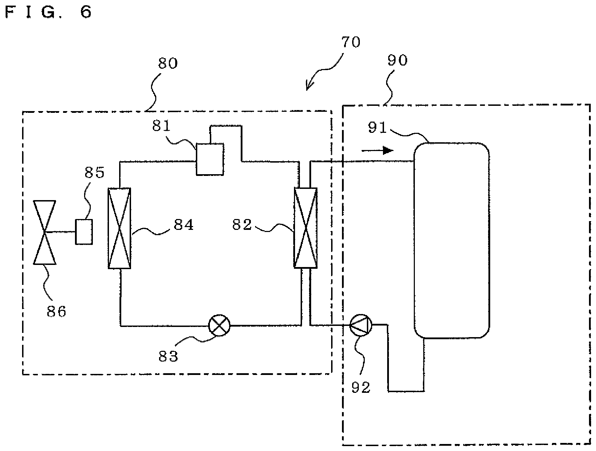

Fig. 6 is a diagram of a refrigerant circuit forming a water heater according to Embodiment 4 of the present invention.

A water heater 70 according to Embodiment 4 includes a refrigeration cycle section 80 and a water-heating circuit 90. The refrigeration cycle section 80 includes a compressor 81 that compresses a refrigerant, a water-refrigerant heat exchanger 82, an expansion valve 83, and a refrigerant-air heat exchanger 84 that are annularly connected to one another in that order with refrigerant pipes, whereby a refrigerant circuit is formed. The refrigeration cycle section 80 further includes a fan 86 that is driven by a motor 85 and sends the outdoor air toward the refrigerant-air heat exchanger 84. The refrigeration cycle section 80 is provided outdoors.

The water-heating circuit 90 includes the water-refrigerant heat exchanger 82, a hot water tank 91, and a pump 92. Water pipes connected to the water-refrigerant heat exchanger 82 are separated from the refrigerant pies of the refrigerant circuit. The water-refrigerant heat exchanger 82, the hot water tank 91 , and the pump 92 included in the water-heating circuit 90 are annularly connected to one another in that order with the water pipes. The pump 92 corresponds to the fluid pump 30 according to Embodiment 2 described above.

An operation of the refrigeration cycle section 80 will first be described.

A high-temperature, high-pressure gas refrigerant discharged from the compressor 81 flows into the water-refrigerant heat exchanger 82, where the gas refrigerant exchanges heat with the water flowing through the water pipe by transferring its heat to the water, whereby the gas refrigerant is condensed into a liquid refrigerant. The liquid refrigerant undergoes pressure reduction at the expansion valve 83, turns into a low-pressure, two-phase gas-liquid refrigerant or a liquid refrigerant, and flows into the refrigerant-air heat exchanger 84. In the refrigerant-air heat exchanger 84, the low-pressure refrigerant absorbs heat from the outdoor air and thus evaporates, thereby turning into a gas refrigerant. The gas refrigerant is sucked into the compressor 81 again. Thereafter, the above sequence is repeated.

A basic operation of the water-heating circuit 90 will now be described.

The water circulating through the water-heating circuit 90 is sent to the water-refrigerant heat exchanger 82 by the pump 92 and is heated in the water-refrigerant heat exchanger 82 by the heat transferred from the refrigeration cycle section 80

The heated water is sent to the hot water tank 91. The heated water in the hot water tank 91 is sent to the pump 92 again. Thereafter, the above sequence is repeated.

Here, while the temperature of the circulating water that circulates through the water circuit 60 of the air-conditioning apparatus according to Embodiment 3 described above is 60 degrees C or below, the temperature of the circulating water that circulates through the water-heating circuit 90 according to Embodiment 4 is almost 90 degrees C. Hence, if silicon carbide, which is guaranteed to operate at or above 200 degrees C, is used for the main device chip 20 included in the fluid pump 30 of the water heater 70 according to Embodiment 4, a sufficiently wide operating range is secured.

According to the above configuration, the water heater 70 including the motor 10 produces the same effects as in Embodiment 1. Heat of the power conversion circuit included in the motor 10 is transferred to the circulating water intended for heating that circulates through the water-heating circuit 90. Therefore, the heat of the power conversion circuit is also efficiently used for the heating of the water, producing a possible effect of energy saving to some extent.

### Embodiment 5

An apparatus that produces the effects described in Embodiment 1 is provided even if the motor 10 according to Embodiment 1 is applied to any of apparatuses other than the fluid pump 30. For example, the motor 10 may be used as a motor of an air-sending device. If the air-sending device is included in an air-conditioning apparatus, a ventilator, or a water heater, an apparatus that produces the effects described in Embodiment 1 is provided.

### Embodiment 6

In each of Embodiments 1 to 5, the main device chip 20 is made of silicon and a compound of silicon. The main device chip 20 may alternatively be made of any of other wide-bandgap semiconductors such as SiC (silicon carbide), GaN (a gallium-nitride-based material), C (diamond), and the like. In that case also, needless to mention, the same effects are produced.

### Embodiment 7

The main device chip 20 included in the main circuit device 2 according to each of Embodiments 1 to 5 may alternatively be a MOSFET. A MOSFET is characterized in that the conduction resistance increases in accordance with the temperature and the loss is increased. In Embodiment 7, as described above, the heat of the main circuit device 2 is transferred to the fluid. In this manner, the temperature of the main circuit device 2 is made lower than in a case where the heat is transferred to still air. The conduction resistance is reduced with a drop of temperature of the MOSFET device functioning as the main device chip 20. Therefore, a motor with a built-in power conversion circuit that causes lesser losses, a pump including the motor with a built-in power conversion circuit, an air-conditioning apparatus and a water heater each including the pump, and an apparatus including the motor with a built-in power conversion circuit are provided.

### Embodiment 8

Embodiment 8 concerns a specific circuit configuration of the motor with a built-in power conversion circuit.

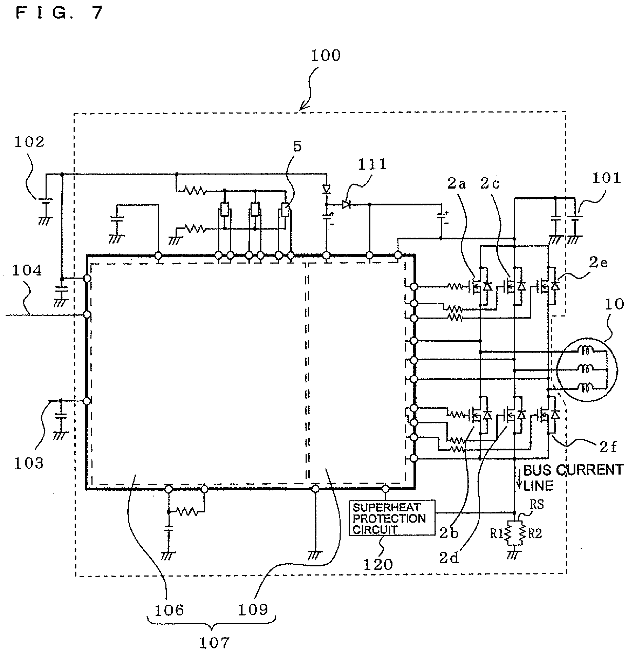

Fig. 7 is a circuit diagram of a motor with a built-in power conversion circuit according to Embodiment 8 of the present invention.

A motor 100 with a built-in power conversion circuit is integrated with a motor 10 in a molded casing. The motor 100 with a built-in power conversion circuit includes a Hall device 5 that detects the rotation of the motor 10, a gate-signal-generating circuit 106, a gate drive circuit 109, a charge pump diode 111, main circuit devices 2a to 2f (each corresponding to the main circuit device 2 according to any of Embodiments described above), and other elements. The motor 100 with a built-in power conversion circuit is connected to a direct-current high-voltage power source 101 obtained through the rectification and smoothing of a commercial alternating-current power source, a direct-current low-voltage power source 102 obtained through voltage reduction of the direct-current high-voltage power source 101, an FG output line 104 through which a pulse signal that is proportional to the rotation speed of the motor 10 is output, and a command input line 103 through which a command regarding the voltage to be output or the rotation speed to be output is supplied at an analog voltage. The main circuit devices 2a to 2f are each a surface-mount MOSFET obtained by providing a MOSFET chip, using a Si chip, in a surface-mount package. The main circuit devices 2a to 2f are each not limited to a MOSFET and may each be an IGBT. Alternatively, which of a MOSFET and an IGBT is to be used may be determined for the individual main circuit devices. A section including the gate drive circuit 109 and the main circuit devices 2a to 2f corresponds to an inverter. The main circuit devices 2a to 2f each employ the connection configuration described above in Embodiment 1 and illustrated in Fig. 3.

The gate-signal-generating circuit 106 is provided on a silicon (Si) IC chip on which the gate drive circuit 109 is provided. The charge pump circuit 111 as the charge pump diode forms a circuit that drives, with the low-voltage power source 102, the gates of the main circuit devices 2a, 2c, and 2e, which are upper switching devices of the inverter. A bus current line is provided with a current-detecting resistor (shunt resistor) RS that detects the current flowing through the bus current line. The shunt resistor RS includes one resistor element or a plurality of resistor elements (in this case, two resistor elements R1 and R2) that are connected in parallel. The level of the current detected by using a shunt current is transmitted to a gate-signal-generating/gate drive IC 107 via a superheat protection circuit 120 to be described below. In the gate-signal-generating/gate drive IC 107, the overcurrent is limited and the main circuit devices 2a to 2f and a rotor magnet of the motor are thus protected from demagnetization. The superheat protection circuit 120 is a circuit that suppresses the rises of temperatures of the main circuit devices 2a to 2f by lowering the level of limitation on the overcurrent and thus lowering the output of the motor 10 when the temperatures of any of the main circuit devices 2a to 2f have risen excessively.

In Embodiment 8, the motor 10 has three phases. A pair of the main circuit devices 2c and 2d in the middle phase are provided between a pair of the main circuit devices 2a and 2b and a pair of the main circuit devices 2e and 2f provided in the other respective phases. The voltage to be applied to the motor 10 is adjusted by pulse-wise modulation (PWM) performed on the main circuit devices 2a, 2c, and 2e on the upper side. Specifically, the duration in which PWM is on is changed in proportion to the command voltage while the main circuit devices 2b, 2d, and 2f on the lower side are constantly powered, whereby the output voltage of the inverter is adjusted. In this configuration, since the main circuit devices 2a, 2c, and 2e on the upper side that are to be subjected to PWM are switched for PWM, the main circuit devices 2a, 2c, and 2e are switched more times and generate more heat than the main circuit devices 2b, 2d, and 2f on the lower side. Furthermore, since the main circuit device 2c is surrounded by the other main circuit devices, more heat concentrates on the main circuit device 2c than on the other main circuit devices.

In Embodiment 8, those of the six main circuit devices (switching devices) 2a to 2f that are on the upper side and generate more heat and those that are on the lower side are provided alternately and adjacent to one another on the counter-stator-side surface 1a of the printed-circuit board 1. Since the switching devices on the upper side that cause greater switching losses because of PWM are arranged so as not to be adjacent to one another, the strength of the devices against breakdown due to heat concentration increases.

Since the superheat-detecting device 3 is provided at a position nearer to the main circuit device 2c than the other main circuit devices, the detection accuracy for the main circuit device 2c that reaches the highest temperature at the occurrence of superheat increases, whereby the protection performance is improved.

Needless to mention, in a case where PWM is performed on the lower side, the same effects are produced by providing the superheat-detecting device 3 at a position nearer to the main circuit device 2d on the lower side than the other main circuit devices.

In a case where PWM is performed uniformly on the main circuit devices on the upper side and the lower side, the same effects are produced by providing the superheat-detecting device 3 at a position near one of the six main circuit devices that is substantially at the center.

### Embodiment 9

Embodiment 9 concerns a specific circuit configuration of the superheat protection circuit 120 according to Embodiment 8 illustrated in Fig. 7.

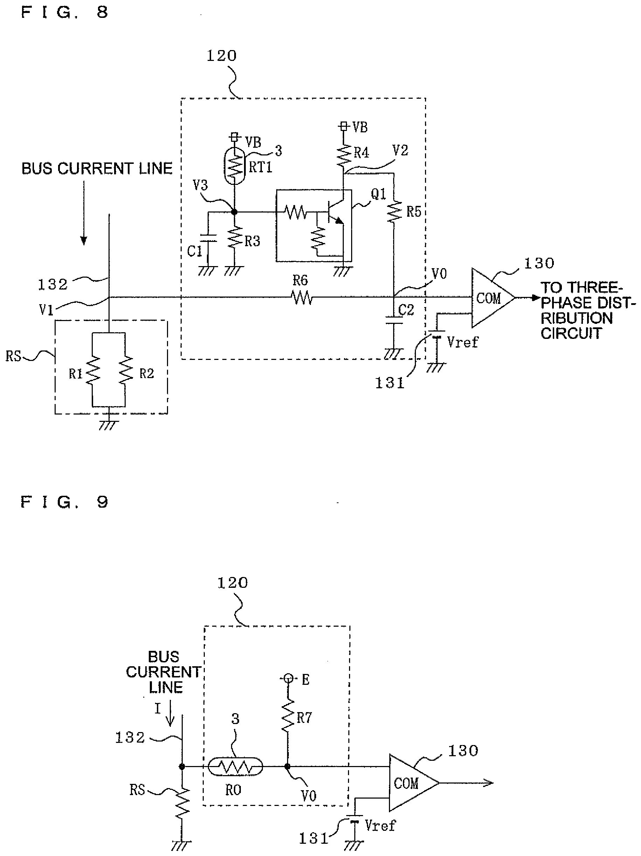

Fig. 8 is a circuit diagram illustrating the superheat protection circuit, the shunt resistor RS, and peripheral elements illustrated in Fig. 7.

The superheat protection circuit 120 according to Embodiment 9 includes a surface-mount, positive-coefficient, temperature-sensitive resistor element 3 corresponding to the superheat-detecting device 3 illustrated in Fig. 1, a voltage divider resistor R3, a resistor R4, a transistor with a built-in resistor (digital transistor) Q1, a resistor R5, a resistor R6, a capacitor C1, and a capacitor C2. A reference voltage of the superheat protection circuit 120 is denoted by VB. A comparator 130 is provided in the main circuit device 2. A reference power source 131 is provided in the gate-signal-generating/gate drive IC 107 illustrated in Fig. 7. In Fig. 8, a bus current line is denoted by 132.

Here, elements around the superheat-detecting device 3 on the printed-circuit board 1 are arranged as illustrated in Fig. 3A, and the output of the superheat-detecting device 3 is amplified by using the digital transistor Q1 . In this manner, thermal protection is provided with no time lag in detection and no errors in detected temperature. Moreover, since the highly voltage-resistant main circuit device 2 as a surface-mount package that is of a small package size and includes a small heat spreader 21 is mounted on the counter stator side while heat is transferred to the fluid via the copper foil 11, the heat-transferring copper foil 13, and the through holes 12 and 12a, a wide operating range that cannot be realized in the conventional configuration is obtained.

In the case where the thermal coupling is enhanced by surrounding the superheat-detecting device 3 with the copper foil 11 that is strongly thermally coupled to the fluid flowing through the space in the cup 8, the detection of the superheat of the fluid for a protection purpose is performed accurately.

In a motor 100 with a built-in power conversion circuit that includes the superheat protection circuit 120 according to Embodiment 9, the heat spreader 21 of the main circuit device 2 is not electrically coupled to the other circuit patterns. Therefore, the performance of insulation between the main circuit device 2 and the low-voltage circuit is improved compared with that of a configuration, which will be described below, including the superheat protection circuit 120 according to Embodiment 8.

### Embodiment 10

Embodiment 10 concerns another specific circuit configuration of the superheat protection circuit 120 described in Embodiment 8 illustrated in Fig. 7, the configuration being different from the one described in Embodiment 9.

Fig. 9 is a circuit diagram illustrating the superheat protection circuit, the shunt resistor RS, and peripheral elements illustrated in Fig. 7.

The superheat protection circuit 120 according to Embodiment 10 includes a resistor R7 and a surface-mount, positive-coefficient, temperature-sensitive resistor element 3 corresponding to the superheat-detecting device 3 illustrated in Fig. 1. The shunt resistor RS according to Embodiment 10 includes one resistor.

In a motor with a built-in power conversion circuit that includes the superheat protection circuit 120 according to Embodiment 10, the heat spreader 21 of the main circuit device 2 is strongly thermally and electrically coupled to the bus current line 132 with solder cream or by flow soldering (the solder not illustrated).

### Reference Signs List

In Embodiment 10, the transistor for amplification is omitted. Hence, the superheat protection circuit 120 is provided at a lower cost than in Embodiment 9. Accordingly, a circuit, a motor, and an apparatus that each include this superheat protection circuit 120 are each provided at a low cost.

In each of Embodiments 8 to 10, six multi-chip MOSFETs are employed as the main circuit devices 2 included in the inverter. Needless to mention, the same effects are also produced with a high-voltage, surface-mount, single-chip inverter IC.

In each of Embodiments 8 to 10, if a highly heat-resistant, small-loss, wide-bandgap semiconductor made of SiC, C, or the like having a high heat-resistant temperature is employed as the main circuit device 2, there are provided larger margins for the errors in detected temperature and the time lag in detection than for the conventional main devices made of Si. Hence, the superheat-detecting device 3 may be a negative-coefficient, temperature-sensitive resistor element (thermistor) or the like whose temperature-resistance characteristic changes a little. In a case where a positive-coefficient, temperature-sensitive resistor element is employed, the same effects are produced even with a lower strength of thermal coupling realized by using the copper foil 11, the heat-transferring copper foil 13, and the through holes 12 and 12a than in the configurations illustrated in the relevant drawings.

In each of Embodiments 8 to 10, if a MOSFET having a superjunction (SJ) structure that causes a smaller steady loss than a normal MOSFET is employed as the main circuit device 2, there are provided margins for the errors in detected temperature and the time lag in detection. Hence, the superheat-detecting device 3 may be a negative-coefficient, temperature-sensitive resistor element (thermistor) or the like whose temperature-resistance characteristic changes a little. In a case where a positive-coefficient, temperature-sensitive resistor element is employed, the same effects are produced even with a lower strength of thermal coupling realized by using the copper foil 11, the heat-transferring copper foil 13, and the through holes 12 and 12a than in the configurations illustrated in the relevant drawings. Particularly, needless to mention, greater effects are produced with a MOSFET that causes a small recovery loss and includes a trap layer acting on a charge accumulated when the diode included in the MOSFET is forward-biased.

In a case where an SJ-MOSFET or a SiC-FET is employed as the main circuit device 2 of a motor with a built-in power conversion circuit that is to be applied to a pump, the strength of thermal coupling realized by using the copper foil 11, the heat-transferring copper foil 13, and the through holes 12 and 12a provided for heat transfer to the fluid flowing through the pump is reduced.

In each of Embodiments described above, the thermal, electrical, or mechanical coupling of the device and each metal member is realized with solder. Needless to mention, the same effects are produced with any other metal, conductive resin, or the like.

In each of Embodiments described above, the printed-circuit board 1 is of a through-hole type. Because of plating performed on the through holes, the copper foil of the through-hole board is thicker than the copper foil of a board having no through holes even if the original copper foil has the same thickness. Therefore, a stronger thermal coupling and a stronger metal barrier are provided. Moreover, the presence of the through holes provides much stronger thermal coupling. Needless to mention, the thicker the copper foil, the greater the effects produced. Furthermore, the larger the number and the size of through holes, the greater the effects produced.

In each of Embodiments described above, a double-sided through-hole board provided with copper foil is employed as the printed-circuit board. Needless to mention, the same effects are produced with a board on which thermal, electrical, and mechanical coupling between the device and each metal part is realized by using any other metal or an insulating material or a board with a circuit that is not formed by etching or the like.

In the pump motor described above, waste heat from heat-generating elements is transferred to the fluid flowing through the pump. Therefore, in a water heater or a heating apparatus using circulating water, heat that is conventionally exhausted to the outside via molded resin is given to the fluid, whereby energy is used efficiently. Particularly, in a case where a main device made of SiC or the like that is operable at a higher temperature than a conventional device made of Si is employed, the temperature difference from the flowing fluid is large. Hence, a great effect of heat recovery is produced.

If the flowing fluid is a highly insulating substance, the cup 8 may be made of a metal having a small thermal resistance. In that case, a particularly great effect of heat recovery is produced. In a case where the flowing fluid is highly conductive, if the cup 8 is made of a highly insulating resin, the performance of insulation between the device and the fluid increases.

In a case where the fluid in the pump is at a low temperature and is solidified before the pump is activated, if a steady loss or a switching loss is made to occur in the main circuit device 2 so that the main circuit device 2 is made to generate heat by powering or switching the drive circuit, there is produced a strong thermal coupling between the main circuit device 2 and the flowing fluid. Therefore, the solidified fluid melts in a short time. Accordingly, additional effects are produced in that the operating limit of the pump at low temperature is raised, and that the pump is activated in a short time.

### Reference Signs List

1 printed-circuit board, 1a counter-stator-side surface, 1b stator-side surface, 2 main circuit device, 3 superheat-detecting device, 4 motor-external-connection lead, 4a high-voltage input line, 4b low-voltage input line, 5 Hall device, 6 motor terminal, 7 molded resin, 8 cup, 9a rotor, 9b stator, 10 motor, 11 copper foil, 11a copper foil, 12 through hole, 12a through hole, 13 heat-transferring copper foil, 14 through hole, 20 main device chip, 21 heat spreader, 21a high-voltage electrode, 22 metal lead frame, 22a low-voltage electrode, 23 metal electrode, 24 bonding wire, 25 resin, 30 fluid pump, 31 impeller, 32 pump housing, 40 air-conditioning apparatus, 50 refrigeration cycle section, 51 compressor, 52 water-refrigerant heat exchanger, 53 expansion valve, 54 refrigerant-air heat exchanger, 60 water circuit, 61 water-air heat exchanger, 62 pump, 70 water heater, 80 refrigeration cycle section, 81 compressor, 82 water-refrigerant heat exchanger, 83 expansion valve, 84 refrigerant-air heat exchanger, 85 motor, 86 fan, 80 refrigeration cycle section, 90 water-heating circuit, 91 hot water tank, 92 pump, 100 motor with a built-in power conversion circuit, 101 direct-current high-voltage power source, 102 direct-current low-voltage power source, 103 command input line, 103 command voltage, 104 output line, 106 gate-signal-generating circuit, 107 gate drive IC, 109 gate drive circuit, 111 charge pump diode, 111 charge pump circuit, 120 superheat protection circuit, 130 comparison circuit, 131 reference power source, 132 bus current line.

## Claims

1. A motor with a built-in power conversion circuit comprising:
a printed-circuit board (1) on which a power conversion circuit including a package of a surface-mount main circuit device (2) is mounted;
a stator (9b) provided on a stator-side surface (1b) of the printed-circuit board (1) that is opposite to a mounting surface (1a) having the main circuit device (2);
**characterised in that** the motor further comprises:
a cup (8) having a cylindrical shape with a closed end and providing a space therein in which a fluid flows, the cup (8) being provided on an inner side of the stator (9b) such that the closed end of the cup (8) is in contact with or in proximity to the stator-side surface of the printed-circuit board (1); and
a heat-transferring copper foil (13) provided over an area of the stator-side surface of the printed-circuit board (1), the area facing the closed end of the cup (8),
wherein, in the main circuit device (2), a heat spreader (21) is bonded to one of two surfaces of a device chip (20) included in the package, the one of the two surfaces facing toward the printed-circuit board (1), and the heat spreader (21) is coupled to the heat-transferring copper foil (13) via a through hole (12) penetrating through the printed-circuit board (1).

2. The motor with a built-in power conversion circuit of claim 1, wherein the coupling between the heat spreader (21) and the printed-circuit board (1) is formed with solder.

3. The motor with a built-in power conversion circuit of claim 1 or 2, wherein the through hole (12) is filled with solder, and the heat spreader (21) is coupled to the heat-transferring copper foil (13) via the solder filled in the through hole (12).

4. The motor with a built-in power conversion circuit of any one of claims 1 to 3, wherein the device chip (20) included in the main circuit device (2) is a MOSFET.

5. The motor with a built-in power conversion circuit of any one of claims 1 to 4, wherein the device chip (20) included in the main circuit device (2) is made of a wide-bandgap semiconductor.

6. The motor with a built-in power conversion circuit of claim 5, wherein the wide-bandgap semiconductor is silicon carbide, a gallium-nitride-based material, or diamond.

7. The motor with a built-in power conversion circuit of any one of claims 1 to 6, further comprising temperature-detecting means (3) provided on the mounting surface (1a) having the main circuit device (2).

8. The motor with a built-in power conversion circuit of claim 7, wherein a copper foil (11) provided between the heat spreader (21) and the printed-circuit board (1) is provided along the printed-circuit board (1) in such a manner as to surround the temperature-detecting means (3), and a portion of the copper foil (11a) surrounding the temperature-detecting means (3) is coupled to the heat-transferring copper foil (13) via the through hole (12a) penetrating through the printed-circuit board (1).

9. The motor with a built-in power conversion circuit of any one of claims 1 to 8, further comprising a plurality of switching devices each functioning as the main circuit device (2), wherein the plurality of switching devices (2) are divided into two groups, switching of one of the two groups of main circuit devices (2) is performed by PWM, and the respective switching devices to be switched by PWM and the respective other switching devices are alternately arranged on the printed-circuit board (1).

10. A fluid pump comprising the motor with a built-in power conversion circuit (100) of any one of claims 1 to 9.

11. An air-conditioning apparatus comprising the fluid pump (62) of claim 10.

12. The air-conditioning apparatus of claim 11, further comprising:
an outdoor unit including a refrigerant-air heat exchanger (54);
a flow control unit including a water-refrigerant heat exchanger (52); and
an indoor unit including a water-air heat exchanger (61),
wherein the fluid pump (62) is provided in a water circuit in which water circulates between the water-refrigerant heat exchanger (52) and the water-air heat exchanger (61).

13. A water heater comprising the fluid pump (92) of claim 10.

14. An apparatus comprising the motor with a built-in power conversion circuit (100) of any one of claims 1 to 9.

## Patentansprüche

1. Motor mit einer eingebauten Leistungsumwandlungsschaltung, umfassend:
eine Leiterplatte (1), auf der eine Leistungsumwandlungsschaltung, umfassend ein Package aus einer oberflächenmontierten Hauptschaltungseinrichtung (2), angebracht ist;
einen Stator (9b), der auf einer statorseitigen Oberfläche (1b) der Leiterplatte (1) vorgesehen ist, die einer Anbringungsoberfläche (1a) gegenüberliegt, die die Hauptschaltungseinrichtung (2) aufweist;
**dadurch gekennzeichnet, dass** der Motor ferner umfasst:
einen Behälter (8) mit einer zylindrischen Form mit einem geschlossenen Ende und einem darin vorgesehenen Raum, in dem ein Fluid strömt, wobei der Behälter (8) auf einer Innenseite des Stators (9b) vorgesehen ist, so dass das geschlossene Ende des Behälters (8) in Kontakt ist mit oder in der Nähe ist von der statorseitigen Oberfläche der Leiterplatte (1); und
eine wärmeübertragende Kupferfolie (13), die über einen Bereich der statorseitigen Oberfläche der Leiterplatte (1) vorgesehen ist,
wobei die Fläche dem Ende des Behälters (8) zugewandt ist,
wobei in der Hauptschaltungseinrichtung (2) ein Wärmeverteiler (21) mit einer von zwei Oberflächen eines im Package enthaltenen Einrichtungschips (20) verbunden ist, wobei die eine der zwei Oberflächen zur Leiterplatte (1) zeigt,
und der Wärmeverteiler (21) mit der wärmeübertragenden Kupferfolie (13) über ein Durchgangsloch (12) gekoppelt ist, das durch die Leiterplatte (1) hindurchgeht.

2. Motor mit einer eingebauten Leistungsumwandlungsschaltung nach Anspruch 1, wobei die Kopplung zwischen dem Wärmeverteiler (21) und der Leiterplatte (1) mit Lot ausgebildet ist.

3. Motor mit einer eingebauten Leistungsumwandlungsschaltung nach Anspruch 1 oder 2, wobei das Durchgangsloch (12) mit Lot gefüllt ist und der Wärmeverteiler (21) mit der wärmeübertragenden Kupferfolie (13) über das in das Durchgangsloch (12) gefüllte Lot gekoppelt ist.

4. Motor mit einer eingebauten Leistungsumwandlungsschaltung nach einem der Ansprüche 1 bis 3, wobei der in der Hauptschaltungseinrichtung (2) enthaltene Vorrichtungschip (20) ein MOSFET ist.

5. Motor mit einer eingebauten Leistungsumwandlungsschaltung nach einem der Ansprüche 1 bis 4, wobei der in der Hauptschaltungsvorrichtung (2) enthaltene Vorrichtungschip (20) aus einem Halbleitermaterial mit breiter Bandlücke gefertigt ist.

6. Motor mit einer eingebauten Leistungsumwandlungsschaltung nach Anspruch 5, wobei das Halbleitermaterial mit breiter Bandlücke Siliziumkarbid, ein Material auf Galliumnitridbasis oder Diamant ist.

7. Motor mit einer eingebauten Leistungsumwandlungsschaltung nach einem der Ansprüche 1 bis 6, ferner umfassend ein Temperaturerfassungsmittel (3), das auf der Anbringungsoberfläche (1a) vorgesehen ist, die die Hauptschaltungseinrichtung (2) aufweist.

8. Motor mit einer eingebauten Leistungsumwandlungsschaltung nach Anspruch 7, wobei eine zwischen dem Wärmeverteiler (21) und der Leiterplatte (1) vorgesehene Kupferfolie (11) entlang der Leiterplatte (1) vorgesehen ist, so dass sie das Temperaturerfassungsmittel (3) umgibt, und ein Teil der Kupferfolie (11a), der das Temperaturerfassungsmittel (3) umgibt, mit der wärmeübertragenden Kupferfolie (13) über das durch die Leiterplatte (1) hindurchgehende Durchgangsloch (12a) gekoppelt ist.

9. Motor mit einer eingebauten Leistungsumwandlungsschaltung nach einem der Ansprüche 1 bis 8, ferner umfassend eine Vielzahl von Schaltungseinrichtungen, die jeweils als die Hauptschaltungseinrichtung (2) funktionieren, wobei die Vielzahl von Schaltungseinrichtungen (2) in zwei Gruppen unterteilt sind, das Schalten einer der zwei Gruppen von Hauptschaltungsrichtungen (2) durch PWM durchgeführt wird und die jeweiligen durch PWM zu schaltenden Schaltungseinrichtungen und die jeweiligen anderen Schaltungseinrichtungen auf der Leiterplatte (1) abwechselnd angeordnet sind.

10. Flüssigkeitspumpe, umfassend den Motor mit einer eingebauten Leistungsumwandlungsschaltung (100) nach einem der Ansprüche 1 bis 9.

11. Klimaanlage, umfassend die Flüssigkeitspumpe (62) nach Anspruch 10.

12. Klimaanlage nach Anspruch 11, ferner umfassend:
eine Außeneinheit, aufweisend einen Kältemittel-Luft-Wärmetauscher (54);
eine Strömungssteuerungseinheit, aufweisend einen Wasser-Kältemittel-Wärmetauscher (52); und
eine Inneneinheit, aufweisend einen Wasser-Luft-Wärmetauscher (61),
wobei die Flüssigkeitspumpe (62) in einem Wasserkreislauf vorgesehen ist, in dem Wasser zwischen dem Wasser-Kältemittel-Wärmetauscher (52) und dem Wasser-Luft-Wärmetauscher (61) zirkuliert.

13. Wassererwärmer, umfassend die Flüssigkeitspumpe (92) nach Anspruch 10.

14. Vorrichtung, umfassend den Motor mit einer eingebauten Leistungsumwandlungsschaltung (100) nach einem der Ansprüche 1 bis 9.

## Revendications

1. Moteur équipé d'un circuit incorporé de conversion de puissance comprenant :
une carte de circuit imprimé (1) sur laquelle est monté un circuit de conversion de puissance incluant un boîtier d'un dispositif de circuit principal monté en surface (2) ;
un stator (9b) fourni sur une surface côté stator (1b) de la carte de circuit imprimé (1) qui est opposée à une surface de montage (1a) présentant le dispositif de circuit principal (2) ;
**caractérisé en ce que** le moteur comprend en outre :
une coupelle (8) ayant une forme cylindrique avec une extrémité fermée et fournissant un espace dans lequel s'écoule un fluide, la coupelle (8) étant fournie sur un côté intérieur du stator (9b) de sorte que l'extrémité fermée de la coupelle (8) est en contact avec la surface côté stator, ou à proximité de la surface côté stator, de la carte de circuit imprimé (1) ; et
une feuille de cuivre à transfert thermique (13) fournie sur une zone de la surface côté stator de la carte de circuit imprimé (1), la zone faisant face à l'extrémité fermée de la coupelle (8),
dans lequel, dans le dispositif de circuit principal (2), un dissipateur de chaleur (21) est lié à l'une des deux surfaces d'une puce de dispositif (20) incluse dans le boîtier, ladite une des deux surfaces faisant face à la carte de circuit imprimé (1), et dans lequel le dissipateur de chaleur (21) est couplé à la feuille de cuivre à transfert thermique (13) par l'intermédiaire d'un trou traversant (12) qui traverse la carte de circuit imprimé (1).

2. Moteur équipé d'un circuit incorporé de conversion de puissance selon la revendication 1, dans lequel le couplage entre le dissipateur de chaleur (21) et la carte de circuit imprimé (1) est réalisé par soudure.

3. Moteur équipé d'un circuit incorporé de conversion de puissance selon la revendication 1 ou 2, dans lequel le trou traversant (12) est rempli d'une soudure et le dissipateur de chaleur (21) est couplé à la feuille de cuivre à transfert thermique (13) par le biais de la soudure remplissant le trou traversant (12).

4. Moteur équipé d'un circuit incorporé de conversion de puissance selon l'une quelconque des revendications 1 à 3, dans lequel la puce de dispositif (20) incluse dans le dispositif de circuit principal (2) est un transistor à effet de champ à semi-conducteur à oxyde métallique, MOSFET.

5. Moteur équipé d'un circuit incorporé de conversion de puissance selon l'une quelconque des revendications 1 à 4, dans lequel la puce de dispositif (20) incluse dans le dispositif de circuit principal (2) est constituée d'un semi-conducteur à large bande interdite.

6. Moteur équipé d'un circuit incorporé de conversion de puissance selon la revendication 5, dans lequel le semi-conducteur à large bande interdite est du carbure de silicium, un matériau à base de nitrure de gallium, ou du diamant.

7. Moteur équipé d'un circuit incorporé de conversion de puissance selon l'une quelconque des revendications 1 à 6, comprenant en outre un moyen de détection de température (3) fourni sur la surface de montage (1a) présentant le dispositif de circuit principal (2).

8. Moteur équipé d'un circuit incorporé de conversion de puissance selon la revendication 7, dans lequel une feuille de cuivre (11) fournie entre le dissipateur de chaleur (21) et la carte de circuit imprimé (1) est fournie le long de la carte de circuit imprimé (1) de manière à entourer le moyen de détection de température (3), et une partie de la feuille de cuivre (11a) entourant le moyen de détection de température (3) est couplée à la feuille de cuivre à transfert thermique (13), par l'intermédiaire du trou traversant (12a) qui traverse la carte de circuit imprimé (1).

9. Moteur équipé d'un circuit incorporé de conversion de puissance selon l'une quelconque des revendications 1 à 8, comprenant en outre une pluralité de dispositifs de commutation opérant chacun en qualité de dispositif de circuit principal (2), dans lequel la pluralité de dispositifs de commutation (2) est divisée en deux groupes, et la commutation de l'un des deux groupes de dispositifs de circuit principal (2) est mise en œuvre par le biais d'une modulation d'impulsions en durée, PWM, et les dispositifs de commutation respectifs devant être commutés par modulation PWM et les autres dispositifs de commutation respectifs sont agencés alternativement sur la carte de circuit imprimé (1).

10. Pompe à fluide comprenant le moteur équipé d'un circuit incorporé de conversion de puissance (100) selon l'une quelconque des revendications 1 à 9.

11. Appareil de climatisation comprenant la pompe à fluide (62) selon la revendication 10.

12. Appareil de climatisation selon la revendication 11, comprenant en outre :
une unité extérieure incluant un échangeur de chaleur de type « fluide frigorigène-air » (54) ;
une unité de régulation de débit incluant un échangeur de chaleur de type « eau-fluide frigorigène » (52) ; et
une unité intérieure incluant un échangeur de chaleur de type « eau-air » (61),
dans lequel la pompe à fluide (62) est fournie dans un circuit d'eau dans lequel de l'eau circule entre l'échangeur de chaleur de type « eau-fluide frigorigène » (52) et l'échangeur de chaleur de type « eau-air » (61).

13. Chauffe-eau comprenant la pompe à fluide (92) selon la revendication 10.

14. Appareil comprenant le moteur équipé d'un circuit incorporé de conversion de puissance (100) selon l'une quelconque des revendications 1 à 9.
